# EUROPEAN PATENT APPLICATION

(11) **EP 4 783 227 A1**
(43) Date of publication of application: **29.07.2026**
(21) Application number: 24867835.1
(22) Date of filing: 27.05.2024
(51) Int. Cl.: H01L 21/304, B08B 3/08, C25B 1/30, C25B 9/13, C25B 9/60, C25B 9/70, C25B 15/08, G03F 1/82, G03F 7/42, H01L 21/027

(54) **SUBSTRATE PROCESSING DEVICE AND SUBSTRATE PROCESSING METHOD**

(30) Priority: 19.09.2023 JP 2023150890
(71) Applicant: SCREEN Holdings Co., Ltd., Kyoto-shi, Kyoto 602-8585 (JP)
(72) Inventor: IWAO Michinori, Kyoto-shi, Kyoto 602-8585 (JP); KAMON Hiroaki, Kyoto-shi, Kyoto 602-8585 (JP); IWAHATA Shota, Kyoto-shi, Kyoto 602-8585 (JP)
(74) Representative: Kilian Kilian & Partner mbB
(86) International application number: PCT/JP2024/019355
(87) International publication number: WO 2025/062748

(57) **Abstract**

A technique disclosed in the specification of the present application is a technique of suppressing damage on an electrolysis cell in substrate processing. A substrate processing apparatus according to a technique disclosed in the specification of the present application includes a substrate processing part, a supply tank, a generation part, a collection part, a first supply route supplying a processing solution generated in the generation part to the supply tank, and a second supply route supplying the processing solution generated in the generation part to the collection part, and the collection part supplies a treated solution with which the processing solution supplied through the second supply route has been mixed to the generation part.

## Description

### TECHNICAL FIELD

A technique disclosed in the specification of the present application relates to a substrate processing technique. A substrate as a processing target includes a semiconductor wafer, a glass substrate for a liquid crystal display device, a flat panel display (FPD) substrate such as an organic electroluminescence (EL) display device, an optical disk substrate, a magnetic disk substrate, a magnetic optical disk substrate, a photomask glass substrate, a ceramic substrate, a field emission display (that is to say, FED) substrate, or solar battery substrate, for example.

### BACKGROUND ART

A mixed solution of sulfuric acid and hydrogen peroxide water (SPM), for example, is conventionally used as a processing solution for substrate processing (for example, refer to Patent Document 1). The SPM is a processing solution generating oxidation power by mixing hydrogen peroxide water with sulfuric acid, and is mainly used for substrate processing of removing a resist formed on an upper surface of the substrate.

### PRIOR ART DOCUMENTS

### PATENT DOCUMENT(S)

Patent Document 1: Japanese Patent Application Laid-Open No. 2018-163977

### SUMMARY

### PROBLEM TO BE SOLVED BY THE INVENTION

In the meanwhile, electrolytic sulfuric acid can be used as a processing solution of substrate processing in place of the SPM in which a large amount of discharge solution is generated as the processing solution. Since the electrolytic sulfuric acid can be used as a processing solution again by electrolyzation even after being used for the substrate processing, the amount of discharge solution can be reduced.

However, if the resist occurring by the substrate processing remains in the solution when the electrolytic sulfuric acid which has been used for the substrate processing is electrolyzed again, there is a problem that an electrolysis cell is damaged and worn.

A technique disclosed in the specification of the present application therefore has been made to solve the above problems, and is a technique for suppressing damage on an electrolysis cell in substrate processing.

### MEANS TO SOLVE THE PROBLEM

A substrate processing apparatus according to a first aspect of a technique disclosed in the specification of the present application includes: a substrate processing part for performing processing on a substrate using a processing solution; a supply tank for storing the processing solution supplied to the substrate processing part; a generation part for generating the processing solution by electrolyzation; a collection part collecting a treated solution as the processing solution supplied to the substrate processing part and supplying the treated solution to the generation part; a first supply route for supplying the processing solution generated in the generation part to the supply tank; and a second supply route as a route different from the first supply route for supplying the processing solution generated in the generation part to the collection part, wherein the collection part supplies the treated solution with which the processing solution supplied through the second supply route has been mixed to the generation part.

A substrate processing apparatus according to a second aspect of a technique disclosed in the specification of the present application relates to the substrate processing apparatus according to the first aspect, further including a first measurement part measuring an amount of the treated solution in the collection part and outputting a measurement result, wherein the generation part controls a flow amount of the processing solution supplied to the collection part based on the measurement result.

A substrate processing apparatus according to a third aspect of a technique disclosed in the specification of the present application relates to the substrate processing apparatus according to the first or second aspect, wherein the generation part includes a first temperature adjustment part for adjusting the treated solution and the processing solution which has been generated to have an electrolysis temperature as a temperature for generating the processing solution by electrolyzation.

A substrate processing apparatus according to a fourth aspect of a technique disclosed in the specification of the present application relates to the substrate processing apparatus according to any one of the first to third aspects, wherein the collection part includes a second temperature adjustment part for adjusting the treated solution to an electrolysis temperature as a temperature for generating the processing solution by electrolyzation.

A substrate processing apparatus according to a fifth aspect of a technique disclosed in the specification of the present application relates to the substrate processing apparatus according to any one of the first to fourth aspects, further including a second measurement part measuring a TOC concentration of the treated solution in the collection part and outputting a measurement result, wherein the generation part controls a flow amount of the processing solution supplied to the collection part based on the measurement result.

A substrate processing method according to a sixth aspect of a technique disclosed in the specification of the present application is a substrate processing method for performing processing on a substrate using a processing solution, including: storing the processing solution supplied to a substrate processing part in a supply tank; performing processing on the substrate using the processing solution in the substrate processing part; collecting a treated solution as the processing solution supplied to the substrate processing part in a collection part and supplying the treated solution to a generation part; and generating the processing solution from a solution including the treated solution by electrolyzation in the generation part; wherein a first supply route for supplying the processing solution generated in the generation part to the supply tank and a second supply route as a route different from the first supply route for supplying the processing solution generated in the generation part to the collection part are provided, and the step of supplying the treated solution to the generation part is a step of supplying the treated solution with which the processing solution supplied through the second supply route has been mixed to the generation part.

### EFFECTS OF THE INVENTION

According to at least the first and sixth aspects of the technique disclosed in the specification of the present application, decomposition of a resist, for example, remaining in the solution can be promoted by supplying the processing solution from the generation tank. Thus, the treated solution is supplied to an electrolysis cell, and damage on the electrolysis cell at a time of electrolyzation can be reduced.

These and other objects, features, aspects and advantages relating to the technique disclosed in the specification of the present application will become more apparent from the following detailed description and the accompanying diagrams.

### BRIEF DESCRIPTION OF DRAWINGS

[Fig. 1] is a diagram illustrating an example of a configuration of a substrate processing apparatus according to an embodiment.
[Fig. 2] is a diagram conceptually illustrating an example of a configuration of a controller exemplified in Fig. 1.
[Fig. 3] is a diagram schematically illustrating an example of a processing unit and a related configuration in the substrate processing apparatus according to the embodiment.
[Fig. 4] is a cross-sectional view illustrating an example of an inner structure of a discharge nozzle.
[Fig. 5] is a diagram illustrating an example of a configuration of the substrate processing apparatus in a circulation state of the discharge nozzle.
[Fig. 6] is a diagram illustrating an example of a configuration of the substrate processing apparatus in a discharge state of the discharge nozzle.
[Fig. 7] is a diagram illustrating an example of a case where a treated solution is circulated to a collection tank in the discharge state of the discharge nozzle.

### DESCRIPTION OF EMBODIMENT(S)

Embodiments are described hereinafter with reference to the appended diagrams. Although detailed features, for example, are also described in the following embodiments for explaining a technique, they are exemplifications, and all of them are not necessary features to be able to implement the embodiments.

Since the diagrams are schematically illustrated, a configuration is appropriately omitted or simplified in the diagrams for convenience of the description. A mutual relationship of sizes and positions of configurations each illustrated in the different diagrams is not necessarily illustrated accurately, but may be appropriately changed. A hatching may be assigned to easily understand contents of the embodiments also in the diagrams which are not cross-sectional views but are plan views, for example.

In the description hereinafter, the same reference numerals will be assigned to the similar constituent elements in the diagrams, and the constituent elements having the same reference numeral have the same name and function. Accordingly, the detailed description on them may be omitted to avoid repetition in some cases.

An expression "comprising", "including", or "having" a certain constituent element is not an exclusive expression for excluding the presence of the other constituent elements unless otherwise described in the specification of the present application.

In the description in the specification of the present application, even when ordinal numbers such as "first" or "second" are stated, the terms are used to facilitate understanding of contents of embodiments for convenience, and therefore, the usage of the ordinal numbers does not limit the indication of the ordinal numbers to ordering in the contents of the embodiments.

In the description in the specification of the present application, even when the terms indicating a specific position or direction such as "up", "down", "left", "right", "side", "bottom", "front", "back", for example, are used, these terms are used to facilitate understanding of contents of embodiments for convenience, and therefore, they have no relationship to a position or a direction in an actual implement.

In the description described in the specification of the present application, "upper surface of ..." or "lower surface of ..." include a state where the other constituent element is formed on an upper surface or a lower surface of a target constituent element in addition to an upper surface itself or a lower surface itself of the target constituent element. That is to say, the description of "B provided to an upper surface of A", for example, does not interrupt intervention of the other constituent element "C" between A and B.

### <Embodiment>

A substrate processing apparatus and a substrate processing method according to the present embodiment are described hereinafter.

### <Configuration of substrate processing apparatus>

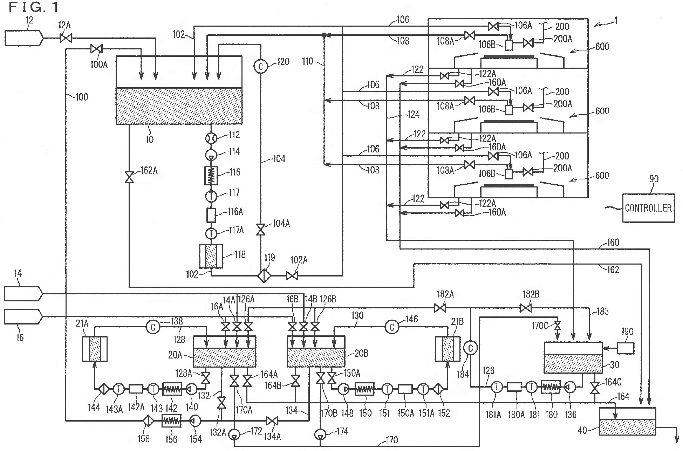

Fig. 1 is a diagram illustrating an example of a configuration of a substrate processing apparatus according to the present embodiment. As exemplified in Fig. 1, a substrate processing apparatus 1 includes a plurality of processing units 600, a supply tank 10, a generation tank 20A, a generation tank 20B, an electrolysis cell 21A, an electrolysis cell 21B, a collection tank 30, a discharge solution tank 40 discharging a processing solution, for example, and a controller 90.

The processing unit 600 performs processing on a substrate using a supplied processing solution. A detailed configuration of the processing unit 600 is described hereinafter. The number of processing unit 600 is not limited to the number thereof illustrated in Fig. 1.

The supply tank 10 stores the processing solution supplied from the generation tank 20A or the generation tank 20B through a supply pipe 100. Then, the supply tank 10 supplies the processing solution to the processing unit 600. Pure water (DIW), hydrogen peroxide water, or ozone water is supplied from a pure water supply source 12 to the supply tank 10. A flow amount of the pure water supplied from the pure water supply source 12 can be adjusted by controlling a valve 12A by the controller 90. The pure water supply source 12 may not be included.

A pipe for supplying the processing solution from the supply tank 10 includes a circulation pipe 102 connected to the supply tank 10 and circulating the processing solution through the supply tank 10, a measurement pipe 104 branched from the circulation pipe 102 and returning the processing solution to the supply tank 10, a supply pipe 106 branched from the circulation pipe 102 and supplying the processing solution to each processing unit 600, a return pipe 108 branched at an end part on a downstream side of each supply pipe 106 and returning the processing solution to a side of the supply tank 10, and a circulation pipe 110 returning the processing solution joined from each return pipe 108 to the supply tank 10.

Provided to a position closer to an upstream side than a position branched at the measurement pipe 104 in the circulation pipe 102 are flowmeter 112 measuring a flow amount of the processing solution, a pump 114 flowing the processing solution, a heater 116 heating the processing solution, a thermometer 117 measuring a temperature of the processing solution, a heat exchanger 116A cooling the processing solution, a thermometer 117A measuring a temperature of the processing solution, and an electrolysis cell 118 electrolyzing the processing solution. The electrolysis cell 118 may not be provided when autolysis of the processing solution is sufficiently suppressed. The heater may be replaced with a mechanism capable of adjusting a temperature including cooling, thus is not limited to case of heating the processing solution. The same applies to a heater described hereinafter.

Provided to the measurement pipe 104 is a concentration meter 120 for measuring a concentration of the processing solution flowing in the measurement pipe 104 (for example, a total organic carbon concentration, that is to say, a TOC concentration). When a concentration of the processing solution measured by the concentration meter 120 is higher than a desired concentration, pure water, for example, is supplied from the pure water supply source 12 to the supply tank 10 by controlling the controller 90. Thus, the concentration of the processing solution can be reduced. When a concentration of the processing solution measured by the concentration meter 120 is lower than a desired concentration, the processing solution is electrolyzed by the electrolysis cell 118 by controlling the controller 90, and water is electrolyzed at the same time. Thus, the concentration of the processing solution can be increased. Water generated by electrolyzation can also be substituted as imparted water.

Provided to positions closer to a downstream side than a position branched at the measurement pipe 104 in the circulation pipe 102 are a filter 119 removing particles in the processing solution and a valve 102A which can adjust a flow amount of the processing solution circulated in the circulation pipe 102 under control of the controller 90.

Provided to the supply pipe 106 is a valve 106A which can adjust a flow amount of the processing solution flowing in the supply pipe 106 under control of the controller 90. Some of the flow amount of the processing solution flowing in the circulation pipe 102 flows in the supply pipe 106.

Provided to the return pipe 108 is a valve 108A which can adjust a flow amount of the processing solution flowing in the return pipe 108 under control of the controller 90.

A position where the return pipe 108 is branched from the supply pipe 106 is provided in the discharge nozzle 106B in the processing unit 600, and furthermore, a mixing pipe 200 mixing imparted water as pure water (DIW), hydrogen peroxide water, or ozone water with the processing solution in the supply pipe 106 is connected to the discharge nozzle 106B. Provided to the mixing pipe 200 is a valve 200A which can adjust a flow amount of the imparted water flowing in the mixing pipe 200 under control of the controller 90.

The imparted water supplied to the mixing pipe 200 may be supplied from the pure water supply source 12, or may also be supplied from a supply source prepared separately.

A pipe for collecting the processing solution from the processing unit 600 includes a discharge solution pipe 122 connected to each processing unit 600 and discharging the processing solution (the treated solution) used for substrate processing, a collection pipe 124 supplying the treated solution joined from each discharge solution pipe 122 to the collection tank 30, a collection pipe 126 connected to the collection tank 30 and supplying the treated solution to the generation tank 20A or the generation tank 20B, a circulation pipe 128 circulating the processing solution between the generation tank 20A and the electrolysis cell 21A, a circulation pipe 130 circulating the processing solution between the generation tank 20B and the electrolysis cell 21B, a supply pipe 132 joining the processing solution from the generation tank 20A to the supply pipe 100, and a supply pipe 134 joining the processing solution from the generation tank 20B to the supply pipe 100. A valve 122A adjusting a flow amount of the discharge solution from the processing unit 600 under control of the controller 90 is provided to the discharge solution pipe 122.

Herein, the plurality of collection tanks 30 may be parallelly provided. That is to say, it is also possible to selectively supply the treated solution from the collection pipe 124 to the plurality of collection tanks and elongate a time before supplying the treated solution from the collection tank to the generation tank. A level sensor 190 measuring an amount of the treated solution stored in the collection tank 30 is provided to the collection tank 30.

Provided to the collection pipe 126 are a pump 136 for transmitting the treated solution stored in the collection tank 30 to the generation tank 20A or the generation tank 20B, a heater 180 heating the treated solution, a thermometer 181 measuring a temperature of the treated solution, a heat exchanger 180A cooling the treated solution, a thermometer 181A measuring a temperature of the treated solution, a concentration meter 184 measuring a concentration of the treated solution (for example, a total organic carbon concentration, that is to say, a TOC concentration), a valve 126A which can adjust a flow amount of the treated solution transmitted to the generation tank 20A under control of the controller 90, and a valve 126B which can adjust a flow amount of the treated solution transmitted to the generation tank 20B under control of the controller 90.

A circulation pipe 183 is provided to be branched from the collection pipe 126. The circulation pipe 183 returns the treated solution to the collection tank 30 and circulates the treated solution. A valve 182A controlling a flow amount of the treated solution flowing into the collection pipe 126 by the controller 90 is provided to a position closer to a downstream than a position branched from the circulation pipe 183 in the collection pipe 126. A valve 182B controlling a flow amount of the treated solution flowing into the circulation pipe 183 by the controller 90 is provided to an upstream side of the circulation pipe 183.

In contrast to the collection pipe 126, a supply pipe 170 for transmitting the processing solution stored in the generation tank 20A or the generation tank 20B to the collection tank 30 is provided to connect the generation tank 20A and the generation tank 20B to the collection tank 30. The supply pipe 170 is provided as a pipe different from the supply pipe 100.

Provided to the supply pipe 170 are a valve 170A for adjusting a flow amount of the processing solution flowing into the supply pipe 170 from the generation tank 20A under control of the controller 90, a pump 172 for transmitting the processing solution flowing into the supply pipe 170 from the generation tank 20A, a valve 170B for adjusting a flow amount of the processing solution flowing into the supply pipe 170 from the generation tank 20B under control of the controller 90, a pump 174 for transmitting the processing solution flowing into the supply pipe 170 from the generation tank 20B, and a valve 170C for adjusting a flow amount of the processing solution flowing into the collection tank 30 from the supply pipe 170 under control of the controller 90.

Provided to the circulation pipe 128 are a valve 128A for adjusting a flow amount of the processing solution flowing in the circulation pipe 128 under control of the controller 90, a concentration meter 138 for measuring a concentration (for example, a total organic carbon concentration, that is to say, a TOC concentration) of the processing solution flowing in the circulation pipe 128, a pump 140 for transmitting the processing solution flowing in the circulation pipe 128, a heater 142 heating the processing solution, a thermometer 143 measuring a temperature of the processing solution, a heat exchanger 142A cooling the processing solution, a thermometer 143A measuring a temperature of the processing solution, and a filter 144 removing particle, for example, in the processing solution.

Provided to the circulation pipe 130 are a valve 130A for adjusting a flow amount of the processing solution flowing in the circulation pipe 130 under control of the controller 90, a concentration meter 146 for measuring a concentration (for example, a total organic carbon concentration, that is to say, a TOC concentration) of the processing solution flowing in the circulation pipe 130, a pump 148 for transmitting the processing solution flowing in the circulation pipe 130, a heater 150 heating the processing solution, a thermometer 151 measuring a temperature of the processing solution, a heat exchanger 150A cooling the processing solution, a thermometer 151A measuring a temperature of the processing solution, and a filter 152 removing particles, for example, in the processing solution.

Provided to the supply pipe 132 is a valve 132A which can adjust a flow amount of the processing solution flowing in the supply pipe 132 under control of the controller 90.

Provided to the supply pipe 134 is a valve 134A which can adjust a flow amount of the processing solution flowing in the supply pipe 134 under control of the controller 90.

Provided to the supply pipe 100 are a pump 154 for transmitting the processing solution flowing in the supply pipe 100, a heater 156 heating the processing solution, a filter 158 removing particles, for example, in the processing solution, and a valve 100A for adjusting a flow amount of the processing solution flowing in the supply pipe 100 under control of the controller 90.

Pure water (DIW), hydrogen peroxide water, or ozone water is supplied from a pure water supply source 14 to the generation tank 20A and the generation tank 20B. A flow amount of the pure water supplied to the generation tank 20A from the pure water supply source 14 can be adjusted by controlling a valve 14A by the controller 90. A flow amount of the pure water supplied to the generation tank 20B from the pure water supply source 14 can be adjusted by controlling a valve 14B by the controller 90. The pure water supply source 14 may not be included.

Sulfuric acid (H₂SO₄) is supplied to the generation tank 20A and the generation tank 20B from a sulfuric acid supply source 16. A flow amount of the sulfuric acid supplied to the generation tank 20A from the sulfuric acid supply source 16 can be adjusted by controlling a valve 16A by the controller 90. A flow amount of the sulfuric acid supplied to the generation tank 20B from the sulfuric acid supply source 16 can be adjusted by controlling a valve 16B by the controller 90. The sulfuric acid supply source 16 may not be included.

The pipe for discharging the processing solution and the treated solution includes a discharge solution pipe 160 for discharging the treated solution from each processing unit 600 to the discharge solution tank 40, a discharge solution pipe 162 for discharging the processing solution from the supply tank 10 to the discharge solution tank 40, and a discharge solution pipe 164 for discharging the processing solution or the treated solution to the discharge solution tank 40 from the generation tank 20A, the generation tank 20B, and the collection tank 30. A valve 160A adjusting a flow amount of the discharge solution from the processing unit 600 under control of the controller 90 is provided to the discharge solution pipe 160. A valve 162A adjusting a flow amount of the discharge solution from the supply tank 10 under control of the controller 90 is provided to the discharge solution pipe 162. Provided to the discharge solution pipe 164 are a valve 164A adjusting a flow amount of the discharge solution from the generation tank 20A under control of the controller 90, a valve 164B adjusting a flow amount of the discharge solution from the generation tank 20B under control of the controller 90, and a valve 164C adjusting a flow amount of the discharge solution from the collection tank 30 under control of the controller 90.

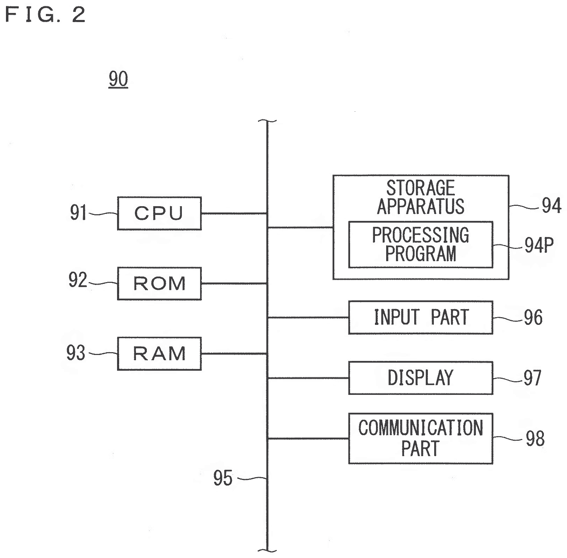

Fig. 2 is a diagram conceptually illustrating an example of a configuration of the controller 90 exemplified in Fig. 1. The controller 90 may be made up of a general computer including an electrical circuit. Specifically, the controller 90 includes a central processing unit (CPU) 91, a read only memory (ROM) 92, a random access memory (RAM) 93, a storage apparatus 94, an input part 96, a display 97, a communication part 98, and a bus line 95 mutually connecting them.

The ROM 92 stores a basic program. The RAM 93 is used as an operation region when the CPU 91 performs predetermined processing. The storage apparatus 94 is made up of a non-volatile storage apparatus such as a flash memory or a hard disk apparatus, for example. The input part 96 is made up of various types of switches and a touch panel, for example, and receives input setting instruction such as a processing recipe from an operator. The display 97 is made up of a liquid crystal display device and a lamp, for example, and displays various types of information under control of the CPU 91. The communication part 98 has a data communication function via a local area network (LAN), for example.

A plurality of modes are previously set for control of each configuration in the substrate processing apparatus 1 in Fig. 1. When the CPU 91 executes a processing program 94P, one of the plurality of modes described above is selected, and each configuration is controlled by the mode. The processing program 94P may be stored in a recording medium. When this recording medium is used, the processing program 94P can be installed on the controller 90. Some or all of the functions executed by the controller 90 need not necessarily be achieved by software, but may also be achieved by hardware such as a dedicated logic circuit.

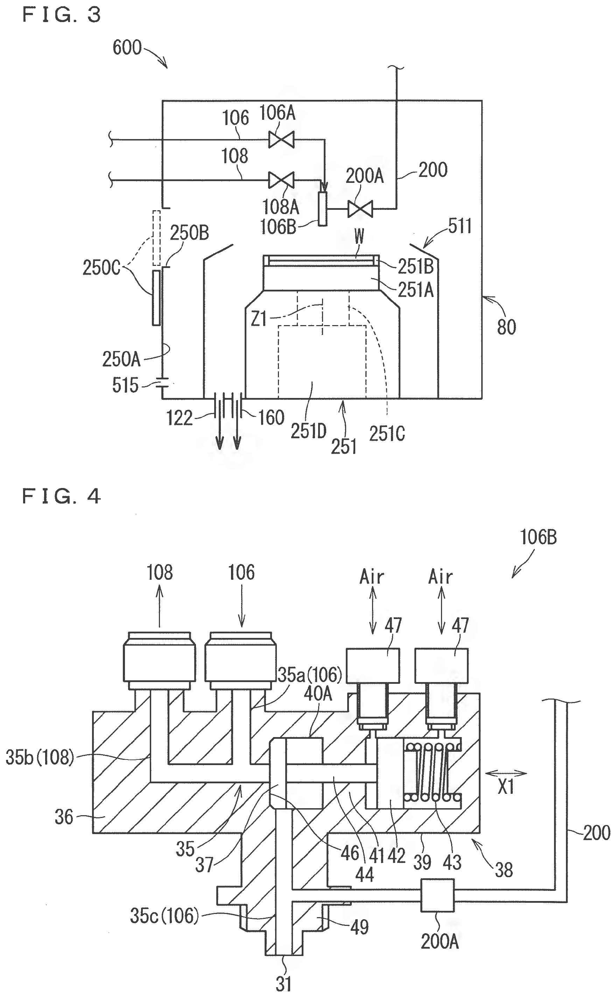

Fig. 3 is a diagram schematically illustrating an example of the processing unit 600 and a related configuration in the substrate processing apparatus according to the present embodiment. Fig, 3 illustrates an example of a configuration of the processing unit 600 disposed on a downstream of one supply pipe 106 in Fig. 1, and a configuration of the processing unit 600 disposed on a downstream of the other supply pipe 106 is also similar to a case exemplified in Fig. 3.

As exemplified in Fig. 3, the processing unit 600 includes a box-like chamber 80 having an inner space, a spin chuck 251 rotating a substrate W around a vertical rotation axis line Z1 passing through a center part of the substrate W while holding one substrate W in a horizontal posture in the chamber 80, and a cylindrical processing cup 511 surrounding the spin chuck 251 around a rotation axis line Z1 of the substrate W.

The chamber 80 is surrounded by a box-like wall 250A. An opening part 250B for transporting the substrate W into and out of the chamber 80 is formed in the wall 250A.

The opening part 250B is opened and closed by a shutter 250C. The shutter 250C is moved up and down between a close position (shown by a dash-double-dot line in Fig. 3) for covering the opening part 250B and an open position (shown by a solid line in Fig. 3) for opening the opening part 250B by a shutter elevating mechanism (not shown herein).

As exemplified in Fig. 3, the spin chuck 251 includes a disk-like spin base 251A provided to face the substrate W in the horizontal posture, a plurality of chuck pins 251B protruding upward from an outer surround part of an upper surface of the spin base 251A and sandwiching a peripheral edge part of the substrate W, a rotation shaft 251C extending downward from a center part of the spin base 251A, and a spin motor 251D rotating the rotation shaft 251C, thereby rotating the substrate W sucked by the spin base 251A.

The spin chuck 251 is not limited to a sandwiching-type chuck exemplified in Fig. 3, but may also be a vacuum suction chuck including a spin base vacuum-sucking a lower surface of the substrate W, for example.

A nozzle for discharging a solution for another purpose (for example, a nozzle discharging another chemical solution or a nozzle discharging a rinse solution) may be connected to the processing unit 600.

As exemplified in Fig. 3, a discharge nozzle 106B discharging the processing solution is connected to a distal end of the supply pipe 106 connected to the processing unit 600. The discharge nozzle 106B discharges the processing solution toward a predetermined portion (for example, the spin base 251A) inside the chamber 80.

The processing cup 511 is provided to surround the spin chuck 251, and is moved up and down in a vertical direction by an elevating mechanism (for example, a motor or a cylinder) not shown in the diagrams. An upper part of the processing cup 511 is moved up and down so that an upper end thereof is located between an upper position above the substrate W held by the spin base 251A and a lower position below the substrate W.

The processing solution flying outside from the upper surface of the substrate W is received on an inner side surface of the processing cup 511. Then, the processing solution received by the processing cup 511 is appropriately discharged to an outer part of the chamber 80 at a bottom part of the chamber 80 through the discharge solution pipe 122 and the discharge solution pipe 160 provided inside the processing cup 511. Atmosphere in the processing cup 511 is exhausted by a cup exhaust mechanism not shown in the diagram.

An exhaust opening 515 is provided to a side part of the chamber 80. The atmosphere in the chamber 80 is appropriately exhausted outside the chamber 80 through the exhaust opening 515.

Fig. 4 is a cross-sectional view illustrating an example of an inner structure of the discharge nozzle 106B.

The discharge nozzle 106B includes a body 36 in which a flow path 35 guiding the processing solution is formed, a valve body 37 opening and closing the flow path 35, a pneumatic actuator 38 making the valve body 37 proceed and retract in an axial direction X1 to open and close the flow path 35, a mixing pipe 200 joined at a position (the flow path 35c) closer to a downstream than the valve body 37 in the flow path 35, and a discharge outlet 31.

The body 36 includes a cylinder 39 constituting the pneumatic actuator 38, a valve room 40A making the valve body 37 proceed and retract, a flow path 35a communicated with the supply pipe 106 to reach the valve room 40A, a flow path 35b communicated with a return pipe 108 and connected to the flow path 35a at a position closer to an upstream than the valve room 40A of the flow path 35a, and a flow path 35c extending from the valve room 40A to the discharge outlet 31.

The cylinder 39 and the valve room 40A are arranged in the axial direction X1. A partition wall 41 separates the cylinder 39 and the valve room 40A. The flow path 35a and the flow path 35c fall under a part of the supply pipe 106 guiding the processing solution supplied from the supply tank 10 toward the discharge outlet 31. The flow path 35b falls under a part of the return pipe 108 returning the processing solution to the supply tank 10.

The pneumatic actuator 38 includes the cylinder 39, a piston 42, a spring 43, and a rod 44. The cylinder 39 is separated by the piston 42 into a front room on a side of the partition wall 41 and a back room on a side opposite thereof in the axial direction X1 with the piston 42 therebetween. Joints 47 for connecting tubes separately transmitting pneumatic pressure to the front room and the back room of the cylinder 39, respectively, are connected to the body 36. The piston 42 transmits pneumatic pressure to any one of the front room and the back room of the cylinder 39 through the tube and the joint 47, thereby proceeding and retracting inside the cylinder 39 along the axial direction X1.

The spring 43 is inserted between the piston 42 and the body 36 on a side of the back room of the cylinder 39, and presses the piston 42 to a direction of the partition wall 41.

The rod 44 includes a base part connected to the piston 42 and a distal end part passing through the partition wall 41 to protrude to the valve room 40A. The valve body 37 is connected to a distal end part of the rod 44 protruding to the valve room 40A. The valve body 37 is formed into a disk-like shape, and is connected to the distal end part of the rod 44 so that a radial direction is perpendicular to the axial direction X1. When the piston 42 proceeds and retracts along the axial direction X1 in the cylinder 39, the valve body 37 proceeds and retracts along the axial direction X1 in the valve room 40A via the road 44.

The valve room 40A includes an annular valve base surface 46 facing the partition wall 41 and perpendicular to the axial direction X1, and the flow path 35a is concentrically opened at a center position of the valve base surface 46. The flow path 35c is opened on a lateral side of a progress-retraction direction of the valve body 37 (the axial direction X1) of the valve room 40A.

The body 36 includes a cylindrical part 49 including a distal end in which the discharge outlet 31 is formed and protruding downward from a lower surface of a nozzle head 26. The mixing pipe 200 is inserted from a lateral side of the cylindrical part 49, and the mixing pipe 200 is connected to the flow path 35c at a position closer to a downstream than the valve room 40A.

In a state where pneumatic pressure does not act on any of the front room and the back room of the cylinder 39 and the pneumatic actuator 38 is not activated, the piston 42 is pressed to a proceeding position, that is to say, a position close to the side of the partition wall 41 as exemplified in Fig. 4 in the cylinder 39 by the spring 43, and the valve body 37 has thereby contact with the valve base surface 46 in the valve room 40A, and opening of the flow path 35a is closed.

Thus, a position between the flow path 35a and the flow path 35c is closed, and the processing solution supplied from the supply tank 10 through the supply pipe 106 and the flow path 35a is returned to the supply tank 10 through the flow path 35b and the return pipe 108 (a circulation state).

In this circulation state, when the pneumatic pressure is transmitted to the front room of the cylinder 39 and the piston 42 retracts to a back room direction of the cylinder 39 against the pressure force of the spring 43, the valve body 37 gets away from the valve base surface 46 in the valve room 40A, and the opening of the flow path 35a is released to the valve room 40A. Thus, when the flow path 35a and the flow path 35c are connected via the valve room 40A, and the processing solution supplied from the supply tank 10 through the supply pipe 106 and the flow path 35a is discharged from the discharge outlet 31 through the flow path 35c (a discharge state).

In this discharge state, when transmission of the pneumatic pressure to the front room of the cylinder 39 is stopped and the pneumatic pressure is alternatively transmitted to the back room of the cylinder 39 to make the piston 42 proceed in a front room direction of the cylinder 39, that is to say, a direction close to the partition wall 41 with the pressing force of the spring 43, the valve body 37 has contact with the valve base surface 46 in the valve room 40A, and the opening of the flow path 35a is closed. Thus, a position between the flow path 35a and the flow path 35c is closed, and the processing solution supplied from the supply tank 10 through the supply pipe 106 and the flow path 35a goes back to the circulation state where the processing solution is returned to the supply tank 10 through the flow path 35b and the return pipe 108.

In the discharge state described above, when the valve 200A is opened and the imparted water is mixed with the processing solution from the mixing pipe 200, a temperature of the processing solution including electrolytic sulfuric acid is increased by reaction heat. Specifically, a temperature of the processing solution is increased to a temperature at a time of being used for substrate processing (a processing temperature).

### <Operation of substrate processing apparatus>

An operation in the substrate treatment apparatus is described next. A substrate processing method by the substrate processing apparatus according to the present embodiment includes: a process of discharging the processing solution to the substrate W transported to the processing unit 600 and performing substrate processing; a process of washing the substrate W on which the substrate processing has been performed; a process of rotating and drying the substrate W which has been washed; and a process of transporting the substrate W which has been dried from the processing unit 600.

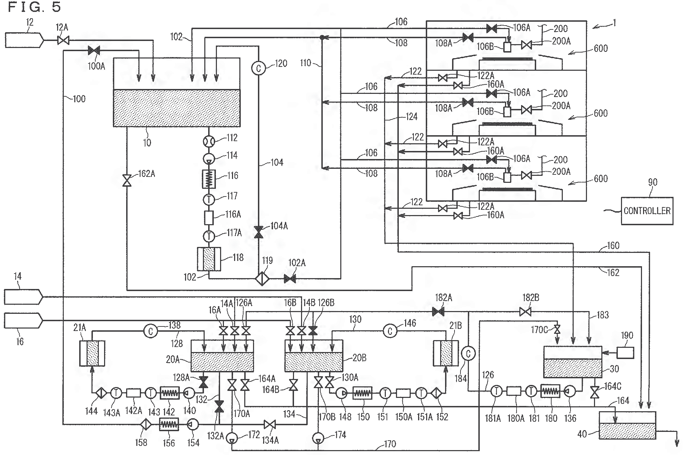

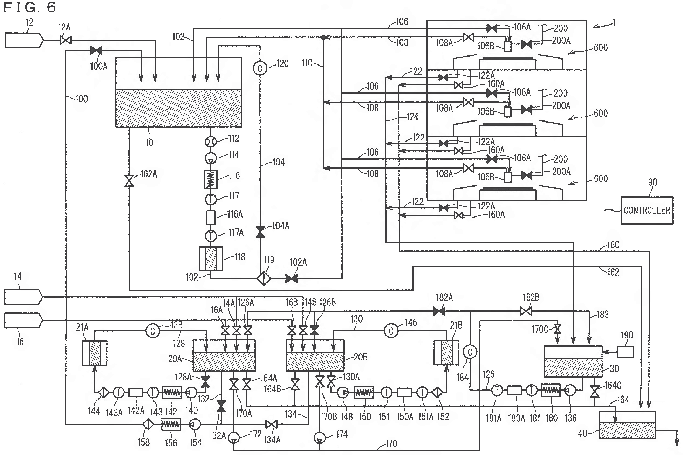

The substrate processing included in the operation in the substrate treatment apparatus described above is described hereinafter with reference to Fig. 5 and Fig. 6. Herein, Fig. 5 is a diagram illustrating an example of a configuration of the substrate processing apparatus in the circulation state of the discharge nozzle 106B. Fig. 6 is a diagram illustrating an example of a configuration of the substrate processing apparatus in the discharge state of the discharge nozzle 106B. Fig. 5 and Fig. 6 illustrates a valve in an open state in black color. The operation described hereinafter is performed by controlling the operation in each configuration (a pump, a heater, a valve, or a spin motor) in the substrate processing apparatus 1 under control of the controller 90.

Firstly, sulfuric acid (H₂SO₄) is circulated between the generation tank 20A and the electrolysis cell 21A through the circulation pipe 128, and the processing solution including electrolytic sulfuric acid is generated. Herein, electrolytic sulfuric acid indicates persulfuric acid (peroxodisulfuric acid, that is to say, H₂S₂O₈) generated by electrolyzing sulfuric acid. Persulfuric acid has larger oxidation power than Caro's acid (H₂SO₅) at the same temperature.

Sulfuric acid is appropriately supplied to the generation tank 20A from the sulfuric acid supply source 16 by controlling the valve 16A by the controller 90. Pure water (DIW), for example, is appropriately supplied from the pure water supply source 14 by controlling the valve 14A by the controller 90. As described hereinafter, the treated solution is supplied to the generation tank 20A from the collection tank 30 by controlling the valve 126A by the controller 90.

A temperature of the processing solution stored in the generation tank 20A is adjusted to 60 °C or less by the heater 142 and the heat exchanger 142A in the circulation pipe 128 in the open state of the valve 128A. Then, particles, for example, are appropriately removed by the filter 144, and the processing solution is transmitted to the electrolysis cell 21A by the pump 140. Since heat may be generated at a time of electrolytic processing (electrolyzation) in the electrolysis cell 21A, the heat exchanger 142A is preferably included to adjust the temperature of the processing solution to 60 °C or less. When the temperature of the processing solution is adjusted to 60 °C or less (an electrolysis temperature), a generation rate of electrolytic sulfuric acid in the case of electrolyzing sulfuric acid is increased. When the temperature of the processing solution is adjusted to 60 °C or less, autolysis of electrolytic sulfuric acid into Caro's acid (H₂SO₅) and OH radical is suppressed.

Then, when sulfuric acid having the temperature adjusted by the electrolysis cell 21A is electrolyzed, the processing solution including electrolytic sulfuric acid and sulfuric acid is generated. Herein, since water molecules in the processing solution are also electrolyzed in electrolyzing sulfuric acid, a concentration of the processing solution increases as the electrolyzation proceeds. The concentration of the processing solution including electrolytic sulfuric acid is measured by the concentration meter 138, and the controller 90 controls a flow amount of the processing solution transmitted to the electrolysis cell 21A based on the measured concentration (that is to say, since opening and closing of the valve 128A is controlled, the flow amount of the processing solution is increased when the measured concentration is low, and is reduced when the measured concentration is high). When the concentration of electrolytic sulfuric acid gets low, a generation efficiency of persulfuric acid increases.

The generation tank 20A described above has a lengthy configuration with the generation tank 20B. Thus, sulfuric acid (H₂SO₄) is circulated between the generation tank 20B and the electrolysis cell 21B through the circulation pipe 130 in the manner similar to the case of the generation tank 20A, and the processing solution including electrolytic sulfuric acid is generated.

Sulfuric acid is appropriately supplied to the generation tank 20B from the sulfuric acid supply source 16 by controlling the valve 16B by the controller 90. Pure water (DIW), for example, is appropriately supplied from the pure water supply source 14 by controlling the valve 14B by the controller 90. As described hereinafter, the treated solution is supplied to the generation tank 20B from the collection tank 30 by controlling the valve 126B by the controller 90.

A temperature of the processing solution stored in the generation tank 20B is adjusted to an electrolysis temperature (for example, 60 °C or less) by the heater 150 and the heat exchanger 150A in the circulation pipe 130 in the open state of the valve 130A. Then, particles, for example, are appropriately removed by the filter 152, and the processing solution is transmitted to the electrolysis cell 21B by the pump 148. Since heat may be generated at a time of electrolytic processing (electrolyzation) in the electrolysis cell 21B, the heat exchanger 150A is preferably included to adjust the temperature of the processing solution to 60 °C or less.

Then, when sulfuric acid having the temperature adjusted by the electrolysis cell 21B is electrolyzed, the processing solution including electrolytic sulfuric acid and sulfuric acid is generated. The concentration of the processing solution including electrolytic sulfuric acid is measured by the concentration meter 146, and the controller 90 adjusts a flow amount of the processing solution transmitted to the electrolysis cell 21B based on the measured concentration by controlling opening and closing of the valve 130A.

The generation tank 20A and the generation tank 20B can switchably supply the processing solution to the supply tank 10. For example, as exemplified in Fig. 5, it is also possible that the valve 132A is opened and processing solution is supplied from the generation tank 20A to the supply tank 10 while the valve 128A is opened and the processing solution is circulated by the circulation pipe 128, and during this time, the valve 130A and the valve 134A are closed and the treated solution is stored in the generation tank 20B from the collection tank 30. When the concentration of electrolytic sulfuric acid stored in the generation tank 20A does not reach a desired concentration, the valve 130A and the valve 134A are opened and the processing solution circulated in the circulation pipe 130 and having a concentration reaching a desired concentration can be supplied to the supply tank 10 from the generation tank 20B while the valve 128A is opened, the valve 132A is closed, circulation of the processing solution is continued in the circulation pipe 128, and the concentration of the processing solution is increased by electrolyzing sulfuric acid. That is to say, even when the processing solution is being generated in one generation tank (the electrolysis cell), the processing solution can be continuously supplied from the other generation tank.

A temperature of the processing solution supplied from any one of (or both) generation tanks is adjusted to 60 °C or less, for example, by the heater 156 in the supply pipe 100. Then, particles, for example, are appropriately removed by the filter 158, and the processing solution is transmitted to the supply tank 10 by the pump 154 via the valve 100A in the open state.

The processing solution supplied from the generation tank via the supply pipe 100 is stored in the supply tank 10. Pure water (DIW), for example, is appropriately supplied from the pure water supply source 12 to the supply tank 10, and the concentration of the processing solution is adjusted.

A temperature of the processing solution transmitted from the supply tank 10 through the circulation pipe 102 is adjusted by the heater 116 so that a temperature measured by the thermometer 117 in the circulation pipe 102 is 60 °C or less, particles, for example, are appropriately removed by the filter 119, and the processing solution is transmitted to be returned to the supply tank 10 again by the pump 114. The controller 90 grasps the substrate processing performed in the processing unit 600 with reference to a processing recipe and adjusts a flow amount of the processing solution circulated in the circulation pipe 102 by opening and closing the valve 102A, for example, so that a flow amount of the processing solution measured by the flowmeter 112 is sufficient for the substrate processing.

The valve 104A adjusting a flow amount under control of the controller 90 and the concentration meter 120 are provided to the measurement pipe 104 branched from the circulation pipe 102. The controller 90 refers to a concentration of the processing solution measured by the concentration meter 120, and performs control of opening the valve 12A and supplying pure water, for example, to the supply tank 10 from the pure water supply source 12 or electrolyzing the processing solution by the electrolysis cell 118 and increasing a concentration of the processing solution, for example.

The supply pipe 106 branched to each processing unit 600 is provided on the downstream side of the circulation pipe 102, and when the corresponding valve 106A is opened under control of the controller 90, the processing solution can be appropriately supplied to the processing unit 600.

In the circulation state (the state where the valve body 37 has contact with the valve base surface 46 in Fig. 4) in the discharge nozzle 106B, the valve 106A and the valve 108A are opened, and the processing solution supplied from the circulation pipe 102 to the supply pipe 106 and further to the return pipe 108 is joined with the circulation pipe 110 and is returned to the supply tank 10. In this manner, when the processing solution flows into the discharge nozzle 106B in the supply pipe 106 and is circulated, change of a temperature of the processing solution caused by a difference of a temperature between the pipe and the processing solution can be suppressed in discharging the processing solution and performing the substrate processing. It is preferable that a flow amount of the processing solution supplied through the return pipe 108 in the circulation state is suppressed to a lower limit for maintaining the temperature of the pipe.

In the discharge state (the state where the valve body 37 in Fig. 4 is located away from the valve base surface 46) of the discharge nozzle 106B, the valve 108A is closed while the valve 106A is opened, and the processing solution is discharged toward the upper surface of the substrate W from the discharge outlet 31 of the discharge nozzle 106B. Then, the substrate processing is performed.

Herein, the imparted water is mixed with the processing solution in the flow path 35c from the mixing pipe 200 in which the valve 200A is in the open state immediately before the processing solution is discharged from the discharge outlet 31. When the imparted water such as pure water is mixed with the processing solution including electrolytic sulfuric acid, a temperature of the processing solution is increased by reaction heat and reaches approximately 90 °C, for example.

When the temperature of electrolytic sulfuric acid is increased by the imparted water, oxidation power of electrolytic sulfuric acid is increased. Thus, substrate processing (for example, resist detachment processing) can be performed with high efficiency using the processing solution without increasing the temperature by a heater, for example. When ozone water as the imparted water is mixed to electrolytic sulfuric acid, there is a possibility that oxidation power of ozone water itself is added and the processing solution has larger oxidation power.

Since electrolytic sulfuric acid includes both persulfuric acid and Caro's acid, the processing solution has high oxidation power compared with substrate processing with single Caro's acid at the same temperature.

The processing solution discharged to the substrate W and used for the substrate processing flows into the discharge solution pipe 122 via the valve 122A in the open state as the treated solution. The treated solution includes sulfuric acid (SO₄²⁻). Then, the treated solution is joined with the collection pipe 124 and is collected in the collection tank 30.

Electrolytic sulfuric acid collected and electrolyzed again can be used for the substrate processing again. Thus, when the substrate processing is performed using the processing solution including electrolytic sulfuric acid, a discharge solution in accordance with the substrate processing can be reduced.

The treated solution stored in the collection tank 30 can be selectively transmitted to (that is to say, any one of or both) the generation tank 20A by opening the valve 126A and the generation tank 20B by opening the valve 126B by the pump 136 through the collection pipe 126.

When the valve 182A and the valve 182B are operated to be selectively opened and closed by the collection pipe 126, a case of transmitting the treated solution to a side of the generation tank and a case of circulating the treated solution via the collection tank 30 can be switched.

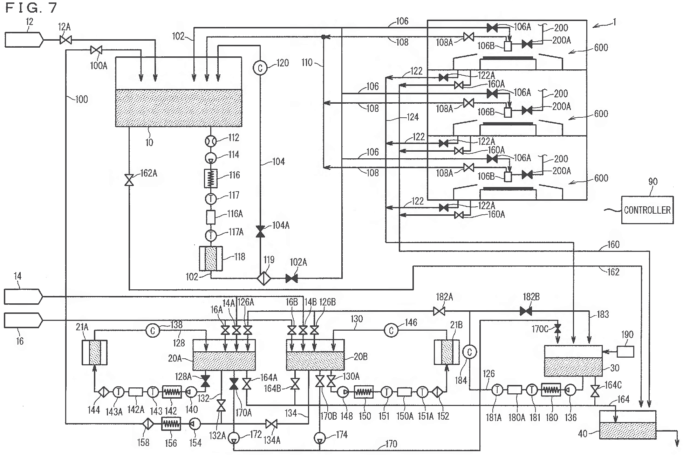

Fig. 7 is a diagram illustrating an example of a case where the treated solution is circulated to the collection tank 30 in the discharge state of the discharge nozzle 106B.

After the substrate processing, when a temperature of the treated solution does not sufficiently get low, as exemplified in Fig. 7, it is possible to make an opportunity of further adjusting the temperature of the treated solution by the heater 180 and the heat exchanger 180A by opening the valve 182B and circulating the treated solution. A time for electrolyzing a resist described hereinafter can be ensured by the circulation.

Herein, a resist, for example, detached from the substrate in the substrate processing remains in the treated solution supplied to the generation tank 20A or the generation tank 20B from the collection tank 30.

In the meanwhile, a surface of the electrolysis cell as a diamond electrode is oxidized by water molecule (H₂O). It is known that the resist as an organic substance also extracts carbon atoms forming the electrolysis cell together with oxygen atoms in a surface of the electrolysis cell at a time of oxidation dissolution (organic substance → CO₂+nH⁺).

Then, the electrolysis cell is worn by electrolyzing the treated solution in which the resist, for example, remains by the electrolysis cell. Although the remaining resist is dissolved by oxidation power of the treated solution, when the dissolution is insufficient, the electrolysis cell is damaged (worn).

In contrast, according to the present embodiment, the supply pipe 170 is included; thus, the processing solution stored in the generation tank 20A or the generation tank 20B can be transmitted to the collection tank 30. For example, as illustrated in Fig. 7, when the valve 170A is opened, the processing solution stored in the generation tank 20A can be transmitted to the collection tank 30 through the supply pipe 170. When the processing solution stored in the generation tank 20A or the generation tank 20B is transmitted to the collection tank 30, the processing solution generated with a sufficiently high concentration by electrolyzation in the electrolysis cell can be mixed with the treated solution collected in the collection tank 30 through the discharge solution pipe 122.

Then, oxidation power of the treated solution stored in the collection tank 30 increases, and dissolution of the resist, for example, remaining in the solution is promoted. Since an amount of the resist remaining in the treated solution supplied to the generation tank through the collection pipe 126 is reduced, the treated solution is supplied to the treated solution and damage on the electrolysis cell at the time of electrolyzation can be reduced.

A temperature of the processing solution stored in the generation tank 20A or the generation tank 20B is sufficiently adjusted by the heater 142, the heat exchanger 142A, the heater 150, and the heat exchanger 150A, and is adjusted to 60 °C or less. Thus, when the processing solution is mixed to the treated solution stored in the collection tank 30, a temperature of the treated solution stored in the collection tank 30 can be reduced. Then, heat generated in resist dissolution can be offset and adjustment range of the temperature can be reduced also in a case where the processing solution is circulated in the circulation pipe 128 or the circulation pipe 130 to adjust the temperature.

Herein, an amount of the processing solution supplied through the supply pipe 170 is controlled by the controller 90 so that the treated solution after being mixed has a desired concentration and temperature with reference to a measurement result of the level sensor 190 in the collection tank 30.

When the valve 132A, the valve 134A, the valve 170A, and the valve 170B are controlled, the processing solution can be supplied to any one of or both the supply pipe 170 and the supply pipe 100.

### <Effect generated by embodiments described above>

Described next is an example of an effect generated by the embodiments described above. In the description hereinafter, the effect is described based on a specific example exemplified in the embodiments described above. However, the specific example may be replaced with the other specific configuration exemplified in the specification of the present application. That is to say, in the description hereinafter, only one of the associated specific configurations is described as a representative in some cases. However, the specific configuration described as the representative may be replaced with the other associated specific configuration.

According to the embodiments described above, the substrate processing apparatus includes the substrate processing part, the supply tank 10, the generation part, the collection part, the first supply route, and the second supply route. Herein, the substrate processing part corresponds to the processing unit 600 including the discharging nozzle 106B, for example. The generation part corresponds to the generation tank 20A, the generation tank 20B, the electrolysis cell 21A, and the electrolysis cell 21B, for example. The collection part corresponds to the collection tank 30 including the collection pipe 124 and the collection pipe 126, for example. The first supply route corresponds to the supply pipe 100, for example. The second supply route corresponds to the supply pipe 170, for example. The processing unit 600 performs processing on the substrate using the processing solution. The supply tank 10 stores the processing solution supplied to the processing unit 600. The generation part generates the processing solution by electrolyzation. The collection tank 30 collects the treated solution as the processing solution supplied to the processing unit 600. Then, the collection tank 30 supplies the treated solution to the generation part. The supply pipe 100 is the pipe supplying the processing solution generated in the generation part to the supply tank 10. The supply pipe 170 is the pipe supplying the processing solution generated in the generation part to the collection tank 30. The supply pipe 170 is the pipe different from the supply pipe 100. Herein, the generation part supplies the processing solution from at least one of the supply pipe 100 and the supply pipe 170. The collection tank 30 supplies the treated solution with which the processing solution supplied through the supply pipe 170 has been mixed to the generation part.

According to such a configuration, the processing solution is supplied from the generation tank. Thus, oxidation power of the treated solution stored in the collection tank 30 can be increased and dissolution of the resist, for example, remaining in the solution can be promoted. Thus, the treated solution is supplied to an electrolysis cell, and damage on the electrolysis cell at a time of electrolyzation can be reduced.

Even in a case where the other configurations other than the configurations exemplified in the specification of the present application is appropriately added to the configuration described above, that is to say, the other configurations in the specification of the present application which are not referred to as configurations described above are appropriately added, the similar effects can be produced.

According to the embodiments described above, the substrate processing apparatus includes the measurement part measuring the amount of the treated solution in the collection tank 30 and outputting the measurement result. Herein, the measurement part corresponds to the level sensor 190, for example. Then, the generation part controls the amount of the processing solution supplied to the collection tank 30 based on the measurement result. According to such a configuration, the amount of the processing solution supplied through the supply pipe 170 can be adjusted so that the treated solution after being mixed has a desired concentration and temperature. According to the embodiments described above, the substrate processing apparatus includes the measurement part measuring the TOC concentration of the treated solution in the collection tank 30 and outputting the measurement result. The measurement part herein corresponds to the concentration meter 184, for example. Then, the generation part controls the amount of the processing solution supplied to the collection tank 30 based on the measurement result. According to such a configuration, the amount of the processing solution supplied through the supply pipe 170 can be adjusted so that the treated solution after being mixed has a desired concentration and temperature.

According to the embodiments describe above, the generation part includes the first temperature adjustment part for adjusting the treated solution and the generated processing solution to have the electrolysis temperature as the temperature for generating the processing solution by electrolyzation. Herein, the first temperature adjustment part corresponds to the heater 142, the heat exchanger 142A, the heater 150, and the heat exchanger 150A, for example. According to such a configuration, the temperature of the processing solution can be maintained so that deactivation of electrolytic sulfuric acid is suppressed. Heat which may be generated in electrolyzation can be effectively offset.

According to the embodiments described above, the collection tank 30 includes the second temperature adjustment part for adjusting the treated solution to have the electrolysis temperature as the temperature for generating the processing solution by electrolyzation. Herein, the second temperature adjustment part corresponds to the heater 180 and the heat exchanger 180A, for example. According to such a configuration, the temperature is adjusted by the heater 180 and the heat exchanger 180A. Thus, the temperature of the treated solution having a high temperature due to the substrate processing is reduced, and deactivation of electrolytic sulfuric acid can be suppressed. The range of temperature adjustment necessary for the generation tank can be reduced.

According to the embodiments described above, the supply tank 10 stores the processing solution supplied to the processing unit 600 in the substrate processing method. The processing unit 600 performs processing on the substrate W using the processing solution. The treated solution as the processing solution supplied to the processing unit 600 is collected in the collection tank 30 and supplied to the generation part. Then, the processing solution is generated from the solution including the treated solution by electrolyzation in the generation part. Herein, the substrate processing apparatus performing the substrate processing includes the supply pipe 100 for supplying the processing solution generated in the generation part to the supply tank 10 and the supply pipe 170 as the route different from the supply pipe 100 for supplying the processing solution generated in the generation part to the collection tank 30. The process of supplying the treated solution to the generation part is the process of supplying the treated solution with which the processing solution supplied through the supply pipe 170 has been mixed to the generation part.

According to such a configuration, the processing solution is supplied from the generation tank. Thus, oxidation power of the treated solution stored in the collection tank 30 can be increased and dissolution of the resist, for example, remaining in the solution can be promoted. Thus, the treated solution is supplied to the electrolysis cell, and damage on the electrolysis cell at the time of electrolyzation can be reduced.

An order of performing each processing can be changed unless otherwise particularly limited.

Even in a case where the other configurations other than the configurations exemplified in the specification of the present application is appropriately added to the configuration described above, that is to say, the other configurations in the specification of the present application which are not referred to as configurations described above are appropriately added, the similar effects can be produced.

### <Modification example of embodiments described above>

Although the substate processing is performed using electrolytic sulfuric acid in the embodiments described above, a mixing solution of sulfuric acid and hydrogen peroxide water (SPM), for example, may be used as the processing solution.

Also in this case, electrolytic sulfuric acid is heated to generate sulfuric acid having a high temperature in a stage of generating electrolytic sulfuric acid in the generation tank and supplying electrolytic sulfuric acid to the supply tank 10 or a stage of supplying electrolytic sulfuric acid to each processing unit 600 from the supply tank 10 or in both stages. Furthermore, when hydrogen peroxide water as imparted water is mixed from the mixing pipe 200, the processing solution for the substrate processing can be generated.

Also when SPM is used as the processing solution, water molecules in the processing solution are electrolyzed in electrolyzing sulfuric acid, the concentration which has been lowered by the imparted water is increased, and electrolytic sulfuric acid can be generated.

In the embodiments described above, material properties, materials, dimensions, shapes, relative arrangement relations, conditions for implementation, and so forth for the respective constituent elements may be described in the above embodiments. However, these represent a mare example in all aspects, and are not limited.

Accordingly, it is understood that numerous modification examples and equivalents which are not exemplified can be devised without departing from the scope of the technique disclosed in the specification of the present application. For example, the technique disclosed in the specification of the present application includes a case of deforming, adding, or omitting at least one constituent element.

Further, in at least one embodiment described above, when names of materials are stated unless otherwise specified, an alloy of the material and other additives, and so forth are included, so far as consistent with the embodiments.

### EXPLANATION OF REFERENCE SIGNS

1 substrate processing apparatus
10 supply tank
21A electrolysis cell
21B electrolysis cell
118 electrolysis cell
170 supply pipe

## Claims

1. A substrate processing apparatus, comprising:
a substrate processing part for performing processing on a substrate using a processing solution;
a supply tank for storing the processing solution supplied to the substrate processing part;
a generation part for generating the processing solution by electrolyzation;
a collection part collecting a treated solution as the processing solution supplied to the substrate processing part and supplying the treated solution to the generation part;
a first supply route for supplying the processing solution generated in the generation part to the supply tank; and
a second supply route as a route different from the first supply route for supplying the processing solution generated in the generation part to the collection part, wherein
the collection part supplies the treated solution with which the processing solution supplied through the second supply route has been mixed to the generation part.

2. The substrate processing apparatus according to claim 1, further comprising
a first measurement part measuring an amount of the treated solution in the collection part and outputting a measurement result, wherein
the generation part controls a flow amount of the processing solution supplied to the collection part based on the measurement result.

3. The substrate processing apparatus according to claim 1 or 2, wherein
the generation part includes a first temperature adjustment part for adjusting the treated solution and the processing solution which has been generated to have an electrolysis temperature as a temperature for generating the processing solution by electrolyzation.

4. The substrate processing apparatus according to claim 1 or 2, wherein
the collection part includes a second temperature adjustment part for adjusting the treated solution to an electrolysis temperature as a temperature for generating the processing solution by electrolyzation.

5. The substrate processing apparatus according to claim 1 or 2, further comprising
a second measurement part measuring a TOC concentration of the treated solution in the collection part and outputting a measurement result, wherein
the generation part controls a flow amount of the processing solution supplied to the collection part based on the measurement result.

6. A substrate processing method for performing processing on a substrate using a processing solution, comprising:
storing the processing solution supplied to a substrate processing part in a supply tank;
performing processing on the substrate using the processing solution in the substrate processing part;
collecting a treated solution as the processing solution supplied to the substrate processing part in a collection part and supplying the treated solution to a generation part, and
generating the processing solution from a solution including the treated solution by electrolyzation in the generation part; wherein
a first supply route for supplying the processing solution generated in the generation part to the supply tank and
a second supply route as a route different from the first supply route for supplying the processing solution generated in the generation part to the collection part are provided, and
the step of supplying the treated solution to the generation part is a step of supplying the treated solution with which the processing solution supplied through the second supply route has been mixed to the generation part.
